**Europäisches Patentamt**

**European Patent Office**

**Office européen des brevets**

(19)

(11) Publication number: **0 100 817**
**B1**

(12)

# EUROPEAN PATENT SPECIFICATION

(45) Date of publication of patent specification: **05.04.89**

(21) Application number: **83104133.0**

(22) Date of filing: **27.04.83**

(51) Int. Cl.⁴: **H 01 L 23/04,** H 01 L 23/10, H 01 L 21/50

(54) A hermetically sealed casing of an electrical device and process of manufacturing.

(30) Priority: **05.08.82 US 405640**

(43) Date of publication of application: **22.02.84 Bulletin 84/08**

(45) Publication of the grant of the patent: **05.04.89 Bulletin 89/14**

(84) Designated Contracting States: **DE FR GB IT NL**

(56) References cited:
**FR-A-1 284 534**
**FR-A-1 362 234**
**FR-A-1 551 426**
**FR-A-2 118 752**
**GB-A-2 073 082**
**US-A-3 340 602**

(73) Proprietor: **Olin Corporation 427 North Shamrock Street East Alton Illinois 62024 (US)**

(72) Inventor: **Butt, Sheldon H. 1904 Arrowhead Lane Godfrey Illinois 62035 (US)**

(74) Representative: **Klunker, Hans-Friedrich, Dr. et al Patentanwälte Klunker . Schmitt-Nilson . Hirsch Winzererstrasse 106 D-8000 München 40 (DE)**

Courier Press, Leamington Spa, England.

**Description**

The invention relates to a hermetically sealed casing of an electrical device, comprising:
a metal or metal alloy base member;
a metal or metal alloy lead frame having first and second opposite surfaces;
the electrical device mounted to said base member and connected to said lead frame;
a metal or metal alloy window frame shaped means having a first surface and an opposite second surface;
a metal or metal alloy lid having a first surface;
glass or ceramic means for bonding said lead frame between said base member and said first surface of said window frame shaped means;
solder means bonding said second surface of said window frame shaped means to said first surface of said lid, whereby said electrical device is substantially hermetically sealed within said casing.

Hermetically sealed packages are used in applications in which maximum reliability is required. This is usually accomplished with ceramics or metals which are impervious to water vapor or other contaminants in the package together with sealing glasses which are also impervious to diffusion. Characteristically, the present hermetic packages cost much more than a plastic package, generally in the order of ten times greater.

In producing a hermetically sealed package, the present technology often uses the following sequence of operations. First, a preformed and prefired ceramic substrate is provided. A metallized spot is applied to the center of this substrate to provide for later attachment of a semiconductor chip. Typically, the metallized spot is gold and the ceramic is normally aluminum oxide (alumina). Under exceptional circumstances, when high thermal dissipation is mandatory, the ceramic substrate may be produced from beryllium oxide. However, this is usually avoided because of the very high cost of beryllium oxide ceramics. Next, a layer of sealing glass is silk screened as a paste around the periphery of the substrate. Then, a lead frame is placed upon the glass and the resulting subassembly is passed through a furnace so that the glass fuses, bonding to the ceramic as well as to the lead frame. Normally, the lead frame material is striped with aluminum in its central area to provide an aluminum surface where lead wires are to be subsequently bonded.

Typically, a low expansivity metal alloy such as 42 nickel—58 iron is used for the lead frame. These alloys are chosen because it is quite advantageous for the coefficient of thermal expansion of the alloy to approximately match that of the ceramic. The glass in turn is selected to provide a coefficient of thermal expansion comparable to that of the 42 nickel alloy and the ceramic. Close matching of coefficients of thermal expansion is required in order to maintain bond integrity and/or to avoid fracture of the glass. Either or both of these failures may result from the stresses developed while the package is cooling from the sealing temperature. Glass sealing alloys such as the 42 nickel alloy are relatively expensive. Their cost is approximately twice the cost of normal copper alloys. Furthermore, the thermal and electrical conductivity of the typical glass sealing alloys is relatively low, approximately 4% that of pure copper. (Alloy 6381 has about 10% the thermal conductivity of pure copper). To promote adhesion between a lead frame of 42 nickel alloy or similar compositions and the glass, it is generally necessary to add a preoxidizing operation to develop a suitable oxide layer upon the surface of the metal for bonding to the glass.

The chip is now bonded to the metallized spot on the substrate using a standard gold-silicon eutectic braze bonding technique. The interconnection between the chip and the lead frame may be made by bonding small diameter lead wires between the two.

Next, sealing glass is silk screened upon the surface of the upper ceramic component. Finally, the upper component is placed over the previous subassembly and again fired so as to fuse the glass which bonds the package together into a single hermetic unit.

The preceding discussion has generally described the process of producing a typical "leaded" hermetic glass-ceramic package.

Various other techniques are known in the art for hermetically sealing semiconductor devices in a metal package. For example, cold pressure welding is used to hermetically seal a metal housing as taught in U.S. Patent No. 2,999,194 to Boswell et al. and in U.S. Patent No. 3,988,825 to Fuchs et al. In addition, hermetically sealing an enclosure without the use of heat is disclosed in U.S. Patent No. 3,113,252 to Matea.

U.S. Patent No. 3,435,516 to Kilby discloses, for example, " . . . methods of fabricating packages for semiconductor devices and methods for mounting and/or sealing bars of thin semiconductive materials having various circuit connections and terminals formed thereon".

A general review of hermetic sealing is disclosed in an article entitled "Hermetic Packages and Sealing Techniques", by Aaron Weiss in *Semiconductor International*, June, 1982.

U.S. Patent No. 3,546,363 to Pryor et al. discloses a composite metal product for use as a seal to glasses and ceramics which has properties of a low coefficient of expansion, approximating that of the appropriate glasses and ceramics, good thermal conductivity, and fine grain size in the annealed condition.

A hermetically sealed casing as indicated at the beginning of the specification is known from U.S. Patent No. 3,340,602 to Hontz, except for the alternative to use ceramic means for bonding the lead frame between the base member and the window frame shaped means. This prior art document teaches a gold

2

plated window frame shaped means, a gold plated lid, and a gold-tin alloy solder for soldering the window frame and the lid to each other.

It is the problem underlying the invention to provide a reliable, sealed casing for an electrical device at relatively low cost.

Accordingly, the casing is characterized in that said window frame shaped means comprises a refractory oxide layer on said first surface; and that such metal(s) or metal alloy(s) of said window frame shaped means and said lid are provided that said window frame shaped means and said lid are readily solderable to each other.

U.S. Patent Nos. 3,546,363; 3,618,203; 3,676,292; 3,726,987; 3,826,627; 3,826,629; 3,837,895; 3,852,148; and 4,149,910 disclose glass or ceramic to metal composites or seals wherein the glass or ceramic is bonded to a base alloy having a thin film of refractory oxide on its surface.

The electrical device may be mounted to the base member by being affixed or bonded to a central pad of the lead frame.

The invention obviates one or more of the limitations and disadvantages of the described prior art arrangements. Relatively inexpensive materials may be used. The invention permits rapid wire bonding and high speed of productivity. Problems associated with mismatch between the coefficient of thermal expansion of the electrical device and the alloy to which it is attached are minimized. The invention allows for relatively low temperature packaging after the electrical device is installed.

The invention further relates to a process for hermetically sealing a casing of an electrical device, comprising the steps of: providing a metal or metal alloy base member; providing a metal or metal alloy lead frame having first and second opposite surfaces; providing a metal or metal alloy window frame shaped means having a first surface and an opposite second surface; glass or ceramic bonding said lead frame between said base member and said first surface of said window frame shaped means; mounting said electrical device to said base member and connecting it to said lead frame; providing a metal or metal alloy lid having a first surface; soldering said second surface of said window frame shaped means to said first surface of said lid whereby said electrical device is substantially hermetically sealed within said casing, characterized by providing said window frame shaped means with a refractory oxide layer on said first surface; and providing such metal(s) or metal alloy(s) of said window frame shaped means and said lid that said window frame shaped means and said lid are readily solderable to each other.

More specific embodiments of the invention are subject of the dependent claims.

Accordingly, there has been provided a hermetically sealed casing and a process for producing the casing. This casing includes a lead frame having an electrical device affixed thereto. A base member is glass bonded to a matching surface of the lead frame. A metal window frame shaped device is provided having one surface with a refractory oxide coating and a second opposite readily solderable surface. The refractory oxide layer of the window frame device is glass bonded to the lead frame. The semiconductor or electrical device is connected to the lead frame after the window frame has been glass bonded into place. A metal lid having a solderable surface is solder bonded to the solderable surface of the window frame to hermetically seal the electrical device within the casing.

Figure 1 is an exploded view of the elements of a hermetically sealed semiconductor casing adapted for assembly in accordance with the present invention; and

Figure 2 is a side view in cross section of a hermetically sealed semiconductor casing in accordance with the present invention.

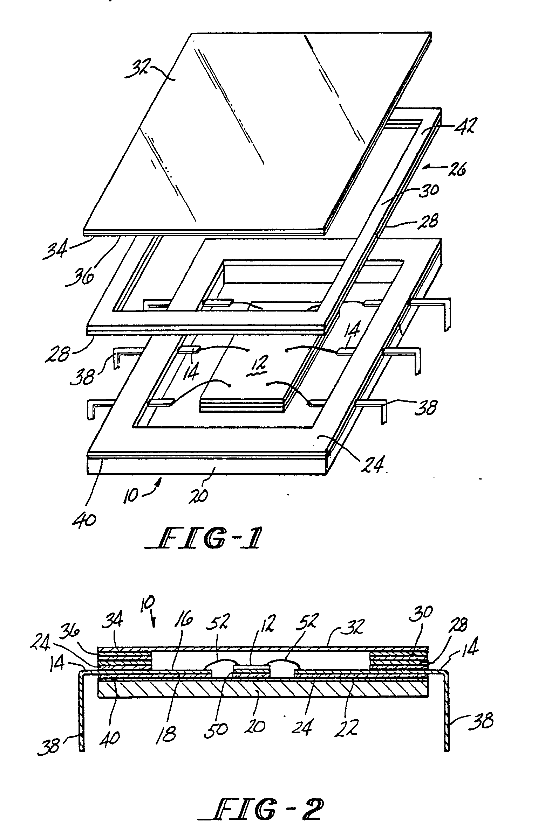

An improved hermetically sealed casing 10, as seen in Figures 1 and 2, for an electrical device 12 is disclosed. A metal or metal alloy lead frame 14 has first and second opposite surfaces 16 and 18 and the electrical device or chip 12 affixed thereto. A metal or metal alloy base member has a surface 22 which is bonded by glass 24 to the second surface 18 of the lead frame. A metal or metal alloy window frame shaped device 26 has at least a first surface 28 with a refractory oxide coating (not illustrated). The window frame 26 also has a second opposite surface 30 which is readily solderable. A metal or metal alloy lid or cover 32 has at least a first readily solderable surface 34. Solder 36 is interposed between the second surface 30 of the window frame device and the first surface 34 of the lid 32 so that the electrical component 12 is substantially hermetically sealed within the casing 10.

The metal substrate or base member 20 may consist primarily of a high thermal conductivity metal or metal alloy such as for example copper or aluminum metals or alloys. To provide improved glass bonding strength, the high conductivity metal or alloy substrate may be completely formed or preferably clad with a thin layer 40 of any desired metal or alloy which bonds strongly with a glass bonding agent. The preferred metal or alloy of the present invention which bonds with a glass bonding agent has a thin refractory oxide layer on its surface. The preferred alloy is a copper base alloy containing from 2 to 12% aluminum and the balance copper. Preferably, the alloy contains from 2 to 10% aluminum, 0.001 to 3% silicon and, if desired, a grain refining element selected from the group consisting of iron up to 4.5%, chromium up to 1%, zirconium up to 0.5%, cobalt up to 1% and mixtures of these grain refining elements and the balance copper. In particular, CDA alloy C6381 containing 2.5 to 3.1% aluminum, 1.5 to 2.1% silicon, and the balance copper is useful as a substrate layer 40 for this invention. Also, CDA alloy C638, as disclosed in U.S. Patent No. 3,676,292 to Pryor et al., is suitable. Alloy C638 is similar to C6381 except for the addition of cobalt. Impurities may be present in either alloy which do not prevent bonding in a desired embodiment.

One of the alloys useful with this invention, CDA alloy C6381 as described in U.S. Patent Nos. 3,341,369

3

and 3,475,227 to Caule et al. which disclose copper base alloys and processes for preparing them, have a refractory oxide layer formed to one or more of their surfaces. The oxide layer may include complex oxides formed with elements such as alumina, silica, tin, iron chromia, zinc, and manganese. Most preferably, the refractory oxide layer is substantially aluminum oxide ($Al_2O_3$). The formation of the refractory oxide to the substrate may be accomplished in any desired manner. For example, a copper base alloy such as alloy C6381 may be preoxidized in gases having an extremely low oxygen content. The C6381 may be placed in a container with 4% hydrogen, 96% nitrogen and a trace of oxygen released from a trace of water mixed in the gas. This gas may be heated to a temperature of between about 330°C and about 820°C. Depending on the temperature and amount of time the alloy is left in the heated gas, a refractory oxide layer of a desired thickness forms on the surface of the alloy.

The present invention is not restricted to applications of alloy C6381 but includes the broad field of metal or alloys which have the ability to form continuous refractory oxide layers on their surface. Several examples of other metal alloys such as nickel base and iron base alloys are disclosed in U.S. Patent Nos. 3,698,964, 3,730,779 and 3,810,754. Alloy C6381 is particularly suitable for this invention because it is a commercial alloy which forms such films when heated.

The lead frame 14 is also constructed of a metal or alloy, as described above, which bonds well to glass. Preferably, the lead frame is formed of C6381 and has a refractory oxide formed on surfaces 16 and 18.

As seen in Figure 2, the terminal leads 38 project through the glass component 24 external to the casing 30. Although the terminal leads preferably protrude from two sides of the casing, it is within the scope of the present invention for the terminal leads to extend from any number of sides.

The present invention uses any suitable solder glass or ceramic 24 preferably having a coefficient of thermal expansion/contraction which closely matches the metal components. The glass may be bonded to the thin refractory oxide surface layers on component 40 and lead frame 14 and functions to adhere the metal components together and electrically insulate them from each other. When the glass and the copper alloy substrates preferably have the same or closely matched coefficients of thermal expansion, thermal stresses in the system may be essentially eliminated and the problems associated with thermal stress in the finished product alleviated. However, the specific character of the refractory oxide layer present on the preferred alloys C638 or C6381 allows bonding to solder glasses with significantly lower expansion/contraction coefficients than that of the alloy. It has been demonstrated that mechanically sound bonds can be achieved between C638 and CV432 (contraction coefficient of $127 \times 10^{-7}$°C).

Table I lists various exemplary solder glasses which are adapted for use in accordance with this invention.

TABLE I

| Solder glass or ceramic type | Coefficient of thermal expansion, m/m/°C |
| --- | --- |
| Ferro Corp.[1] No. RN-3066-H | $167 \times 10^{-7}$ |
| Ferro Corp.[1] No. RN-3066-S | $160 \times 10^{-7}$ |
| Owens Illinois[2] No. EJ3 | $160 \times 10^{-7}$ |
| Owens Illinois[2] No. CV432 | $127 \times 10^{-7}$ |

[1]Proprietary composition manufactured by Ferro Corporation, Cleveland, Ohio.
[2]Proprietary composition manufactured by Owens Illinois Corporation, Toledo, Ohio.

The window frame shaped element 26 may be formed of a composite of a metal or alloy having a refractory oxide layer on one surface such as for example CDA alloy C6381 or any other metal or alloy having the ability to form continuous refractory oxide layers on their surface as mentioned hereinabove. This allows the window frame to be securely bonded to glass 24 in a conventional manner. Although the window frame may be formed of a single metal or alloy, it is preferably provided with a cladding 42 of a more readily solderable alloy such as CDA alloy C151.

The lid or top cover 32 is also fabricated from a suitable solderable metal or alloy, such as for example a copper or aluminum metal or alloy, preferably CDA alloy C151, as described above. However, it is within the scope of the present invention to use any solderable metal or alloy to form the lid 32 or component 42 of the window frame 26. The advantage of having the opposing surfaces 34 and 30 of the lid 32 and the window frame 26, respectively, to be readily solderable permits the use of much less expensive solders and eliminates the need to gold plate the components as in the prior art.

The solder 36 may be comprised of any conventional solder depending on the requirements of the application. For example, if there is a need to avoid flux, a gold-tin solder mixture might be desirable. Also, in an application having a low temperature restraint, a lead-tin solder might be desirable.

The semiconductor chip 12 is bonded to the pad 50 of the lead frame 14. This bonding may be accomplished by either using a conductive adhesive as is often the case in integrated circuits or a relatively low melting temperature solder. Typically, the plastic adhesives include epoxies and polyimides. They may be formulated with powdered metals, such as silver, to improve their thermal conductivity and/or to provide moderate electrical conductivity. The metal joining materials may include a gold-tin or lead-tin eutectic solder. In addition, it is within the scope of the present invention to use any desired solder or other bonding technique as required.

The interconnection between the chip 12 and the lead frame 14 is typically provided by means of small diameter lead wires 52 (usually gold) which are metallurgically bonded to the tips of the leads in the lead frame and to the chip. The bonding technique is preferably either thermosonic or thermocompression bonding. Thermosonic bonding is a combination of mechanically induced metallurgical bonding at temperatures above ambient in conjunction with the addition of ultrasonic energy. Thermocompression bonding is mechanical deformation at elevated temperature without the addition of the ultrasonic energy. A foil "spider" is often used as an alternative to the wires. The foil itself may be bonded to the chip by either thermosonic or thermocompression bonding. These techniques of bonding are substituted for the slower ultrasonic bonding required for aluminum wires used in the conventional glass sealed hermetic packages.

The sequence of manufacturing the improved hermetic semiconductor casing 10 of the present invention is provided hereinbelow with certain advantages pointed out. First, the lead frame 14 is glass sealed with glass 24 to the refractory oxide surface as cladding 40 of base member 20. Then, the window frame shaped device has its refractory oxide coated surface 28 bonded to the glass 24 which is bonding the lead frame to the metal substrate. Note that the glass may actually be between the metal substrate and the window frame in areas not covered by the lead frame. Although these steps are disclosed as being separate, they may actually be performed concurrently. Now that the high temperature operations are concluded, the semiconductor chip 12 is mounted upon the pad 50. By removing the need to subject the package to relatively high glass sealing temperatures, the chip may be attached to the substrate with a relatively low melting temperature solder or even an organic adhesive. In either case, the problems associated with the mismatch in thermal conductivity between the chip and the pad are minimized. This is due to the fact that the temperature difference between the chip bonding temperature and the ambient temperature is substantially less than in the case of gold-silicon eutectic braze bonding as is often required in conventional hermetically sealed semiconductor casings. In addition, the wires 52 between the lead frame and the chip may be thermocompression or thermosonically bonded. This can eliminate the slower ultrasonic wire bonding used in glass sealed hermetic packages since the final closure using relatively low temperature solder does not have a substantial adverse effect on the bonding wires 52. Finally, a lid or cover 32 is soldered to the window frame to hermetically seal the semiconductor device in the casing 10. Also, the surfaces which are soldered are preferably formed of a readily solderable copper alloy which permits the use of relatively inexpensive solders and eliminates the need to gold plate the soldered components. The solderable metals, as described above, are characteristically substantially less costly than the low expansivity alloys which are frequently used in the present technology.

## Claims

1. A hermetically sealed casing (10) of an electrical device (12), comprising:
a metal or metal alloy base member (20);
a metal or metal alloy lead frame (14) having first and second opposite surfaces (16, 18);
the electrical device (12) mounted to said base member (20) and connected to said lead frame (14);
a metal or metal alloy window frame shaped means (26) having a first surface (28) and an opposite second surface (30);
a metal or metal alloy lid (32) having a first surface (34);
glass or ceramic means (24) for bonding said lead frame (14) between said base member (20) and said first surface (28) of said window frame shaped means (26);
solder means (36) bonding said second surface (30) of said window frame shaped means (26) to said first surface (34) of said lid (32), whereby said electrical device (12) is substantially hermetically sealed within said casing (10), characterized in that said window frame shaped means (26) comprises a refractroy oxide layer on said first surface (28); and
that such metal(s) or metal alloy(s) of said window frame shaped means (26) and said lid (32) are provided that said window frame shaped means (26) and said lid (32) are readily solderable to each other.

2. The casing (10) as in claim 1 characterized by said window frame shaped means (26) being a composite of at least two copper or copper base alloy elements, a first (42) of said at least two elements being readily solderable and a second of said at least two elements having said refractroy oxide layer on said first surface (28).

3. The casing (10) as in claim 2 characterized by said second element consisting of a copper base alloy with 2 to 12% aluminum and the balance essentially copper.

4. The casing (10) as in claim 3 characterized by said copper base alloy being essentially of 2.5 to 3.1% aluminum, 1.5 to 2.1% silicon, and the balance essentially copper.

5. The casing (10) as in any of claims 1 to 4 characterized by said refractory oxide layer including $Al_2O_3$.

6. The casing (10) as in any of claims 1 to 5 characterized by said base member (20) being a copper or copper base alloy having at least a first surface (22) with a refractory oxide layer thereon.

**EP 0 100 817 B1**

7. The casing (10) as in claim 6 characterized by said base member (20) being a copper base alloy comprising 2 to 12% aluminum and the balance essentially copper.

8. The casing (10) as in claim 7 characterized by said base member (20) being a copper base alloy consisting essentially of 2.5 to 3.1% aluminum, 1.5 to 2.1% silicon, and the balance essentially copper.

9. The casing (10) as in any of claims 6 to 8 characterized by said refractory oxide layer of said base member (20) including $Al_2O_3$.

10. The casing (10) as in any of claims 1 to 9 characterized by said base member (20) including a cladding of a substantially high conductivity metal or alloy for providing thermal conductivity from said casing (10).

11. The casing (10) as in any of claims 1 to 10, characterized by said electrical device (12) being a semiconductor chip.

12. A process for hermetically sealing a casing (10) of an electrical device (12), comprising the steps of:
providing a metal or metal alloy base member (20);
providing a metal or metal alloy lead frame (14) having first and second opposite surfaces (16, 18);
providing a metal or metal alloy window frame shaped means (26) having a first surface (28) and an opposite second surface (30);
glass or ceramic bonding said lead frame (14) between said base member (20) and said first surface (28) of said window frame shaped means (26);
mounting said electrical device (12) to said base member (20) and connecting it to said lead frame (14);
providing a metal or metal alloy lid (32) having a first surface (34);
soldering said second surface (30) of said window frame shaped means (26) to said first surface (34) of said lid (32) whereby said electrical device (12) is substantially hermetically sealed within said casing (10), characterized by providing said window frame shaped means (26) with a refractory oxide layer on said first surface (28); and
providing such metal(s) or metal alloy(s) of said window frame shaped means (26) and said lid (32) that said window frame shaped means (26) and said lid (32) are readily solderable to each other.

13. The process as in claim 12 characterized by said window frame shaped means (26) being a composite of at least two copper or copper base alloy elements, a first (42) of said at least two elements being readily solderable and the second of said at least two elements having said refractory oxide layer on said first surface (28).

14. The process as in claim 13 characterized by said second element consisting of a copper base alloy with 2 to 12% aluminum and the balance essentially copper.

15. The process as in claim 14 characterized by said copper base alloy being essentially of 2.5 to 3.1% aluminum, 1.5 to 2.1% silicon, and the balance essentially copper.

16. The process as in any of claims 12 to 15 characterized by said refractory oxide layer including $Al_2O_3$.

17. The process as in any of claims 12 to 16 characterized by said base member (20) being a copper or copper base alloy having at least a first surface (22) with a refractory oxide layer thereon.

18. The process as in claim 17 characterized by said base member (20) being a copper base alloy comprising 2 to 12% aluminum and the balance essentially copper.

19. The process as in claim 18 characterized by said base member (20) being a copper base alloy consisting essentially of 2.5 to 3.1% aluminum, 1.5 to 2.1% silicon, and the balance essentially copper.

20. The process as in any of claims 17 to 19 characterized by said refractory oxide layer of said base member (20) including $Al_2O_3$.

21. The process as in any of claims 12 to 20 characterized by said base member (20) having a cladding of a substantially high conductivity metal or alloy for providing thermal conductivity from said casing (10).

22. The process as in any of claims 12 to 21 characterized by said electrical device (12) being a semiconductor chip.

## Patentansprüche

1. Hermetisch abgedichtetes Gehäuse (10) einer elektrischen Vorrichtung (12), mit:
einem Basisglied (20) aus Metall oder einer Metallegierung;
einem Leiterrahmen (14) aus Metall oder einer Metallegierung, der eine erste sowie eine dieser entgegengesetzte zweite Oberfläche (16, 18) aufweist;
wobei die elektrische Vorrichtung (12) auf dem Basisglied (12) angebracht und mit dem Leiterrahmen (14) verbunden ist;
einer fensterrahmenförmigen Einrichtung (26) aus Metall oder einer Metallegierung, die eine erste Oberfläche (28) sowie eine dieser entgegengesetzte zweite Oberfläche (30) aufweist;
einer Abdeckung (32) aus Metall oder einer Metallegierung, die eine erste Oberfläche (34) aufweist;
einer Einrichtung (24) aus Glas oder Keramikmaterial zum Verbinden des Leiterrahmens (14) zwischen dem Basisglied (20) und der ersten Oberfläche (28) der fensterrrahmenförmigen Einrichtung (26);
Lötmittel (36), durch das die zweite Oberfläche (30) der fensterrahmenförmigen Einrichtung (26) mit der ersten Oberfläche (34) der Abdeckung (32) verbunden ist, wodurch die elektrische Vorrichtung (12) in dem Gehäuse (10) im wesentlichen hermetisch abgedichtet ist, dadurch gekennzeichnet, daß die

6

fensterrahmenförmige Einrichtung (26) eine hitzebeständige Oxidschicht auf der ersten Oberfläche (28) aufweist; und

daß derartige(s) Metall- oder Metallegierungsmaterial(ien) für die fensterrahmenförmige Einrichtung (26) und die Abdeckung (32) vorgesehen ist bzw. sind, daß die fensterrahmenförmige Einrichtung (26) und die Abdeckung (32) leicht miteinander verlötbar sind.

2. Gehäuse (10) nach Anspruch 1, dadurch gekennzeichnet, daß es sich bei der fensterrahmenförmigen Einrichtung (26) um ein Verbundteil aus wenigstens zwei Elementen aus Kupfer oder einer Kupferbasislegierung handelt, wobei ein erstes (42) der wenigstens zwei Elemente einfach verlötbar ist und ein zweites der wenigstens zwei Elemente die hitzebeständige Oxidschicht auf der ersten Oberfläche (28) aufweist.

3. Gehäuse (10) nach Anspruch 2, dadurch gekennzeichnet, daß das zweite Element aus einer Kupferbasislegierung mit 2 bis 12% Aluminium, Rest im wesentlichen Kupfer, besteht.

4. Gehäuse (10) nach Anspruch 3, dadurch gekennzeichnet, daß die Kupferbasislegierung im wesentlichen aus 2,5 bis 3,1% Aluminium, 1,5 bis 2,1% Silizium, Rest im wesentlichen Kupfer, besteht.

5. Gehäuse (10) nach einem der Ansprüche 1 bis 4, dadurch gekennzeichnet, daß die hitzebeständige Oxidschicht $Al_2O_3$ beinhaltet.

6. Gehäuse (10) nach einem der Ansprüche 1 bis 5, dadurch gekennzeichnet, daß es sich bei dem Basisglied (20) um ein Kupfer- oder Kupferbasislegierungsglied handelt, das wenigstens eine erste Oberfläche (22) mit einer darauf befindlichen hitzebeständigen Oxidschicht aufweist.

7. Gehäuse (10) nach Anspruch 6, dadurch gekennzeichnet, daß es sich bei dem Basisglied (20) um eine Kupferbasislegierung mit 2 bis 12% Aluminium, Rest im wesentlichen Kupfer, handelt.

8. Gehäuse (10) nach Anspruch 7, dadurch gekennzeichnet, daß es sich bei dem Basisglied (20) um eine Kupferbasislegierung handelt, die im wesentlichen aus 2,5 bis 3,1% Aluminium, 1,5 bis 2,1% Silizium, Rest im wesentlichen Kupfer, besteht.

9. Gehäuse (10) nach einem der Ansprüche 6 bis 8, dadurch gekennzeichnet, daß die hitzebeständige Oxidschicht des Basisglieds (20) $Al_2O_3$ beinhaltet.

10. Gehäuse (10) nach einem der Ansprüche 1 bis 9, dadurch gekennzeichnet, daß das Basisglied (20) eine Plattierung aus einem Metall oder einer Legierung mit im wesentlichen hoher Leitfähigkeit zur Schaffung thermischer Leitfähigkeit von dem Gehäuse (10) weg beinhaltet.

11. Gehäuse (10) nach einem der Ansprüche 1 bis 10, dadurch gekennzeichnet, daß es sich bei der elektrischen Vorrichtung (12) um einen Halbleiter-Chip handelt.

12. Verfahren zum hermetischen Abdichten eines Gehäuses (10) einer elektrischen Vorrichtung (12), mit folgenden Schritten:

Schaffung eines Basisglieds (20) aus Metall oder einer Metallegierung;

Schaffung eines Leiterrahmens (14) aus Metall oder einer Metallegierung, der eine erste sowie eine dieser entgegengesetzte zweite Oberfläche (16, 18) aufweist;

Schaffung einer fensterrahmenförmigen Einrichtung (26) aus Metall oder einer Metallegierung, die eine erste Oberfläche (28) sowie eine dieser entgegengesetzte zweite Oberfläche (30) aufweist;

Verbinden des Leiterrahmens (14) mit Glas oder Keramik zwischen dem Basisglied (20) und der ersten Oberfläche (28) der fensterrahmenförmigen Einrichtung (26);

Anbringen der elektrischen Vorrichtung (12) auf dem Basisglied (20) und Verbinden derselben mit dem Leiterrahmen (14);

Schaffung einer Abdeckung (32) aus Metall oder einer Metallegierung, die eine erste Oberfläche (34) aufweist;

Verlöten der zweiten Oberfläche (30) der fensterrahmenförmigen Einrichtung (26) mit der ersten Oberfläche (34) der Abdeckung (32), wodurch die elektrische Vorrichtung (12) in dem Gehäuse (10) im wesentlichen hermetisch abgedichtet wird, dadurch gekennzeichnet, daß die fensterrahmenförmige Einrichtung (26) mit einer hitzebeständigen Oxidschicht auf der ersten Oberfläche (28) vorgesehen wird; und

daß derartige(s) Metall- oder Metallegierungsmaterial(ien) für die fensterrahmenförmige Einrichtung (26) und die Abdeckung (32) vorgesehen wird bzw. werden, daß die fensterrahmenförmige Einrichtung (26) und die Abdeckung (32) leicht miteinander verlötbar sind.

13. Verfahren nach Anspruch 12, dadurch gekennzeichnet, daß es sich bei der fensterrahmenförmigen Einrichtung (26) um ein Verbundteil aus wenigstens zwei Elementen aus Kupfer oder einer Kupferbasislegierung handelt, wobei ein erstes (42) der wenigstens zwei Elemente einfach verlötbar ist und ein zweites der wenigstens zwei Elemente die hitzebeständige Oxidschicht auf der ersten Oberfläche (28) aufweist.

14. Verfahren nach Anspruch 13, dadurch gekennzeichnet, daß das zweite Element aus einer Kupferbasislegierung mit 2 bis 12% Aluminium, Rest im wesentlichen Kupfer, besteht.

15. Verfahren nach Anspruch 14, dadurch gekennzeichnet, daß die Kupferbasislegierung im wesentlichen aus 2,5 bis 3,1% Aluminium, 1,5 bis 2,1% Silizium, Rest im wesentlichen Kupfer, besteht.

16. Verfahren nach einem der Ansprüche 12 bis 15, dadurch gekennzeichnet, daß die hitzebeständige Oxidschicht $Al_2O_3$ beinhaltet.

17. Verfahren nach einem der Ansprüche 12 bis 16, dadurch gekennzeichnet, daß es sich bei dem Basisglied (20) um ein Kupfer- oder Kupferbasislegierungsglied handelt, das wenigstens eine erste Oberfläche (22) mit einer darauf befindlichen hitzebeständigen Oxidschicht aufweist.

18. Verfahren nach Anspruch 17, dadurch gekennzeichnet, daß es sich bei dem Basisglied (20) um eine Kupferbasislegierung mit 2 bis 12% Aluminium, Rest im wesentlichen Kupfer, handelt.

19. Verfahren nach Anspruch 18, dadurch gekennzeichnet, daß es sich bei dem Basisglied (20) um eine Kupferbasislegierung handelt, die im wesentlichen aus 2,5 bis 3,1% Aluminium, 1,5 bis 2,1% Silizium, Rest im wesentlichen Kupfer, besteht.

20. Verfahren nach einem der Ansprüche 17 bis 19, dadurch gekennzeichnet, daß die hitzebeständige Oxidschicht des Basisglieds (20) $Al_2O_3$ beinhaltet.

21. Verfahren nach einem der Ansprüche 12 bis 20, dadurch gekennzeichnet, daß das Basisglied (20) eine Plattierung aus einem Metall oder einer Legierung mit im wesentlichen hoher Leitfähigkeit zur Schaffung thermischer Leitfähigkeit von dem Gehäuse (10) weg beinhaltet.

22. Verfahren nach einem der Ansprüche 12 bis 21, dadurch gekennzeichnet, daß es sich bei der elektrischen Vorrichtung (12) um einen Halbleiter-Chip handelt.

**Revendications**

1. Boîtier hermétique (10) pour dispositif électrique (12), comprenant:
un organe de base (20) d'un métal ou d'un alliage métallique, un cadre de connexion (14) d'un métal ou d'un alliage métallique, ayant des première et seconde surfaces opposées (16, 18),
le dispositif électrique (12) étant monté sur l'organe de base (20) et connecté au cadre de connexion (14),
un dispositif (26) en forme de cadre, constitué d'un métal ou d'un alliage métallique et ayant une première surface (28) et une seconde surface opposée (30),
un couvercle (32) d'un métal ou d'un alliage métallique, ayant une première surface (34),
un dispositif de verre ou de céramique (24) destiné à fixer le cadre de connexion (14) entre l'organe de base (20) et la première surface (28) du dispositif en forme de cadre (26), et
un dispositif de soudage (36) fixant la seconde surface (30) du dispositif en forme de cadre (26) à la première surface (34) du couvercle (32), si bien que le dispositif électrique (12) est pratiquement scellé hermétiquement dans le boîtier (10),
caractérisé en ce que le dispositif en forme de cadre (26) comporte une couche d'un oxyde réfractaire formée sur la première surface (28), et
le métal ou alliage ou les métaux ou alliages du dispositif (26) en forme de cadre et du couvercle (32) sont disposés de manière que le dispositif (26) en forme de cadre et le couvercle (32) soient facilement soudables l'un à l'autre.

2. Boîtier (10) selon la revendication 1, caractérisé en ce que le dispositif (26) en forme de cadre est un élément composite d'au moins deux éléments, formé de cuivre ou d'un alliage à base de cuivre, un premier (42) des deux éléments au moins étant facilement soudable et un second des deux éléments au moins ayant la couche d'oxyde réfractaire sur la première surface (28).

3. Boîtier (10) selon la revendication 2, caractérisé en ce que le second élément est constitué d'un alliage à base de cuivre contenant 2 à 12% d'aluminium, le reste étant pratiquement formé de cuivre.

4. Boîtier (10) selon la revendication 3, caractérisé en ce que l'alliage à base de cuivre contient essentiellement 2,5 à 3,1% d'aluminium, 1,5 à 2,1% de silicium et le reste de cuivre pratiquement.

5. Boîtier (10) selon l'une quelconque des revendications 1 à 4, caractérisé en ce que la couche d'oxyde réfractaire contient $Al_2O_3$.

6. Boîtier (10) selon l'une quelconque des revendications 1 à 5, caractérisé en ce que l'organe de base (20) est formé de cuivre ou d'alliage à base de cuivre ayant au moins une première surface (22) qui porte une couche d'un oxyde réfractaire.

7. Boîtier (10) selon la revendication 6, caractérisé en ce que l'organe de base (20) est formé d'un alliage à base de cuivre contenant 2 à 12% d'aluminium et le reste pratiquement de cuivre.

8. Boîtier (10) selon la revendication 7, caractérisé en ce que l'organe de base (20) est un alliage à base de cuivre contenant pratiquement 2,5 à 3,1% d'aluminium, 1,5 à 2,1% de silicium et le reste pratiquement de cuivre.

9. Boîtier (10) selon l'une quelconque des revendications 6 à 8, caractérisé en ce que la couche d'oxyde réfractaire de l'organe de base (20) est formée de $Al_2O_3$.

10. Boîtier (10) selon l'une quelconque des revendications 1 à 9, caractérisé en ce que l'organe de base (20) comporte un revêtement d'un métal ou alliage de conductibilité élevée, assurant la conductibilité thermique du boîtier (10).

11. Boîtier (10) selon l'une quelconque des revendications 1 à 10, caractérisé en ce que le dispositif électrique (12) est une pastille semi-conductrice.

12. Procédé de scellement hermétique d'un boîtier (10) destiné à un dispositif électrique (12) comprenant les étapes suivantes:
la disposition d'un organe de base (20) d'un métal ou d'un alliage métallique,
la disposition d'un cadre de connexion (14) d'un métal ou d'un alliage métallique, ayant des première et seconde surfaces opposées (16, 18),
la disposition d'un dispositif (26) en forme de cadre, constitué d'un métal ou d'un alliage métallique et ayant une première surface (28) et une seconde surface opposée (30),

8

un verre ou une céramique assurant la liaison du cadre de connexion (14) entre l'organe de base (20) et la première surface (28) du dispositif (26) en forme de cadre,

le montage du dispositif électrique (12) sur l'organe de base (20) et sa connexion au cadre de connexion (14),

la disposition d'un couvercle (32) d'un métal ou d'un alliage métallique ayant une première surface (34),

la soudage de la seconde surface (30) du dispositif (26) en forme de cadre à la première surface (34) du couvercle (32) afin que le dispositif électrique (12) soit pratiquement scellé hermétiquement dans le boîtier (10),

caractérisé par la disposition d'une couche d'un oxyde réfractaire sur la première surface (28) du dispositif en forme de cadre (26), et

la disposition du métal ou alliage ou des métaux ou alliages du dispositif (26) en forme de cadre et du couvercle (32) de manière que le dispositif (26) en forme de cadre et le couvercle (32) soient facilement soudables l'un à l'autre.

13. Procédé selon la revendication 12, caractérisé en ce que le dispositif (26) en forme de cadre est un élément composite d'au moins deux éléments de cuivre ou d'un alliage à base de cuivre, un premier (42) des deux éléments au moins étant facilement soudable et le second des deux éléments au moins ayant la couche d'oxyde réfractaire sur la première surface (28).

14. Procédé selon la revendication 13, caractérisé en ce que le second élément est constitué d'un alliage à base de cuivre contenant 2 à 12% d'aluminium, le reste étant pratiquement formé de cuivre.

15. Procédé selon la revendication 14, caractérisé en ce que l'alliage à base de cuivre contient essentiellement 2,5 à 3,1% d'aluminium, 1,5 à 2,1% de silicium et le reste pratiquement de cuivre.

16. Procédé selon l'une quelconque des revendications 12 à 15, caractérisé en ce que la couche d'oxyde réfractaire est formée de $Al_2O_3$.

17. Procédé selon l'une quelconque des revendications 12 à 16, caractérisé en ce que l'organe de base (20) est formé de cuivre ou d'un alliage à base de cuivre, et a au moins une première surface (22) portant une couche d'oxyde réfractaire.

18. Procédé selon la revendication 17, caractérisé en ce que l'organe de base (20) est un alliage à base de cuivre contenant 2 à 12% d'aluminium, le reste étant pratiquement formé de cuivre.

19. Procédé selon la revendication 18, caractérisé en ce que l'organe de base (20) est un alliage à base de cuivre constitué essentiellement de 2,5 à 3,1% d'aluminium, 1,5 à 2,1% de silicium et le reste de cuivre.

20. Procédé selon l'une quelconque des revendications 17 à 19, caractérisé en ce que la couche d'oxyde réfractaire de l'organe de base (20) est constituée essentiellement de $Al_2O_3$.

21. Procédé selon l'une quelconque des revendications 12 à 20, caractérisé en ce que l'organe de base (20) a un revêtement d'un métal ou alliage de conductibilité relativement élevée destiné à assurer la conductibilité thermique du boîtier (10).

22. Procédé selon l'une quelconque des revendications 12 à 21, caractérisé en ce que le dispositif électrique (12) est une pastille semi-conductrice.

FIG-1

FIG-2